(19) Europäisches Patentamt / European Patent Office / Office européen des brevets

(11) **EP 2 109 215 A1**

(12) **EUROPEAN PATENT APPLICATION**

(43) Date of publication:
**14.10.2009 Bulletin 2009/42**

(51) Int Cl.:
*H03F 1/02* (2006.01)      *H03F 3/24* (2006.01)
*H03F 3/72* (2006.01)      *H03F 3/68* (2006.01)

(21) Application number: **09155736.3**

(22) Date of filing: **20.03.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.04.2008 FI 20085285**

(71) Applicant: **Digita OY**
**00521 Helsinki (FI)**

(72) Inventor: **Erkkilä, Vesa**
**02130 Espoo (FI)**

(74) Representative: **Simmelvuo, Markku Kalevi et al**
**Papula Oy**
**Mechelininkatu 1 a**
**00180 Helsinki (FI)**

(54) **METHOD AND SYSTEM FOR IMPROVING LINEARITY AND EFFICENY OF A RADIO TRANSMISSION SYSTEM**

(57)    The present invention discloses a radio transmission system. The system uses parallel signal branches formed by output amplifiers (11, 12) and antenna elements (13, 14), wherein the amplification may be adjusted either linearly or by using fixed amplification or by inactivating the desired amplifiers. The intention is to divide the signal into signal branches so that only the summed signal which is observed in the far field of the transmission antennas may be received and detected correctly. Low output powers allow one to use only one amplifier (11) and high output powers, on the other hand, allow one to use a number of parallel amplifiers (11, 12). A control unit (10, 20) adjusts the amplitudes and phases of the signals which are directed to the amplifiers. The antennas may also be formed as one or more antenna groups (21, 22, 30a-d, 31a-d, 40a-b) which may be disposed for example one upon the other or staggeredly so that the radiation patterns generated by the antenna groups are approximately similar to each other.

Fig. 3a

**Description**

**FIELD OF THE INVENTION**

The invention relates to radio transmission systems and in particular to controlling a number of parallel transmission signal branches and the corresponding antenna elements.

**BACKGROUND OF THE INVENTION**

In radio transmission systems, it is typically desirable to transmit a number of signals on a number of different radio channels. The signal is conveyed from an output amplifier to an antenna or antenna group which transmits the signal as desired. In radio transmission systems it is also essential to achieve sufficiently good efficiency and, on the other hand, to meet the linearity requirements of the system. In addition, efforts are being made to minimize the presence of interference for example so that the signals locate within the desired transmission band as much as possible, and, when using directional antennas, within the desired antenna beam coverage area.

Also in the prior art, one aim has been to make the output amplifier as efficient as possible and to meet the requirements set for linearity.

The focus of the prior art radio transmission systems has been to optimize the transmitted signals in the desired manner, taking into consideration the above-mentioned quality factors.

In the prior art, radio transmission systems have been constructed so that a digitally processed signal is subjected to D/A conversion in one transmission signal branch, the analog signal is transferred to a desired frequency band (up-conversion), the signal level is adjusted as desired (amplifiers) and, if desired, the signal is limited to a desired band by means of a filter positioned after the output amplifier. The output signal is directed to the radio path through an antenna element.

In the prior art approaches, the original signal accordant with the applied modulation is conveyed to all antenna elements, being amplified by a certain amplification and having optionally its phase corrected. During the transmission of the signal, the amplification or the phase is not changed.

A downside of the prior art approaches is that in particular when using modulation methods which require a high degree of linearity, such as OFDM, the efficiency at the output stage is poor. Also minimization of the interference outside the actual transmission channel increases the requirement of linearity.

In the normal prior art power summation, differences in the power of the signals which are to be summed result in losses in the summation.

The situation is particularly problematic when constructing active broadband antenna systems which would transmit signals on a number of different radio channels at the same time. In this case, adding suitable filters which would allow the desired frequency bands and suppress any undesirable signal components to each active antenna element or group would be technically very difficult, and this also increases the costs to a considerable extent, degrading also the reliability of the system.

**OBJECTIVE OF THE INVENTION**

The objective of the invention is to introduce a new type of radio transmission system. In particular, the objective of the invention is to alleviate the problems referred to above, i.e. to provide a transmission system wherein specific attention is paid to the linearity, efficiency and costs.

**SUMMARY OF THE INVENTION**

For the characteristics of the present invention, reference is made to the accompanying claims.

The present invention discloses a method for improving efficiency in a radio transmission system, wherein the input signal of the system is divided into at least two parallel signal branches comprising an output amplifier and a transmission antenna. The method is **characterized in that** the input signals of the signal branches are adjusted so that the output signal of at least one signal branch is not the input signal of the system multiplied by any constant, and that the received signal which is summed in the far field of the transmission antennas is the input signal of the system multiplied by a constant.

In one embodiment of the present invention, the input signal of at least one output amplifier is adjusted within the linear operating range of that output amplifier.

In one embodiment of the present invention, at least one output amplifier is controlled so that the output power of the output amplifier is zero or equal to at least one constant value.

In one embodiment of the present invention, the maximum amplitude or phase or both of the output signal of at least one output amplifier are adjustable.

In one embodiment of the present invention, one linearly adjustable output amplifier is controlled, and, in addition, a desired number of output amplifiers of constant power are controlled, depending on the required output power.

In one embodiment of the present invention, an antenna group is defined as a set of antennas coupled to similar types of output amplifiers.

In one embodiment of the present invention, the antennas of each antenna group are disposed on the same plane, so that the direction patterns of the antenna groups are substantially uniform.

In addition, the inventive idea of the present invention comprises a system for improving efficiency in a radio transmission system. The system comprises at least two parallel signal branches divided from the input signal of the system and comprising an output amplifier and a transmission antenna. The invention is **characterized in that** the system comprises a control unit for adjusting the input signals of the signal branches so that the output signal of at least one signal branch is not the input signal of the system multiplied by any constant, and that the received signal which is summed in the far field of the transmission antennas is the input signal of the system multiplied by a constant.

In one embodiment of the present invention, the control unit of the system is arranged to adjust the input signal of at least one output amplifier within the linear operating range of that output amplifier.

In one embodiment of the present invention, the control unit of the system is arranged to control at least one output amplifier so that the output power of the output amplifier is zero or equal to at least one constant value.

In one embodiment of the present invention, the control unit of the system is arranged to adjust the maximum amplitude or phase or both of the output signal of at least one output amplifier.

In one embodiment of the present invention, the control unit of the system is arranged to control one linearly adjustable output amplifier and at least one output amplifier of constant power, depending on the required output power.

In one embodiment of the present invention, the system further comprises a set of antennas defined as an antenna group wherein the antennas are coupled to similar types of output amplifiers.

In one embodiment of the present invention, the system further comprises the antennas of each antenna group disposed on the same plane so that the direction patterns of the antenna groups are substantially uniform.

In addition, the inventive idea of the present invention comprises a computer program for improving efficiency in a radio transmission system, wherein the input signal of the system is divided into at least two parallel signal branches comprising an output amplifier and a transmission antenna. Further, the computer program comprises program code according to which the computer program, when executed by a data processing device, is arranged to adjust the input signals of the signal branches so that the output signal of at least one signal branch is not the input signal of the system multiplied by any constant, and that the received signal which is summed in the far field of the transmission antennas is the input signal of the system multiplied by a constant.

With the present invention it is possible to improve efficiency and linearity of a transmission system. By summing the signals at the receiving end according to the invention, the power losses of the transmission system are considerably reduced.


**LIST OF FIGURES**


Fig. 1 presents one simplified illustration of the principle of the present invention,
Fig. 2 presents an array of the antenna elements employed in one embodiment of the present invention,
Fig. 3a presents an example of summation of the signals conveyed to the antennas of an antenna group,
Fig. 3b presents another example of summation of the signals conveyed to the antennas of an antenna group,
Fig. 4 presents an example of summation of the signals conveyed to the antennas of an antenna group when one output stage operates at high efficiency on a few power levels,
Fig. 5 presents an example of a control unit utilizing the adjustment of the phase of the signal to the opposite phase, and
Fig. 6 presents an example of a control unit without a linear amplifier, utilizing the adjustment of the phase of the signal to the extent of a desired angle.


**DETAILED DESCRIPTION OF THE INVENTION**


The present invention describes a radio transmission system wherein signals which have been modified from the original signal are conveyed to different antenna elements so that they are summed in the far field to form the original desired signal.

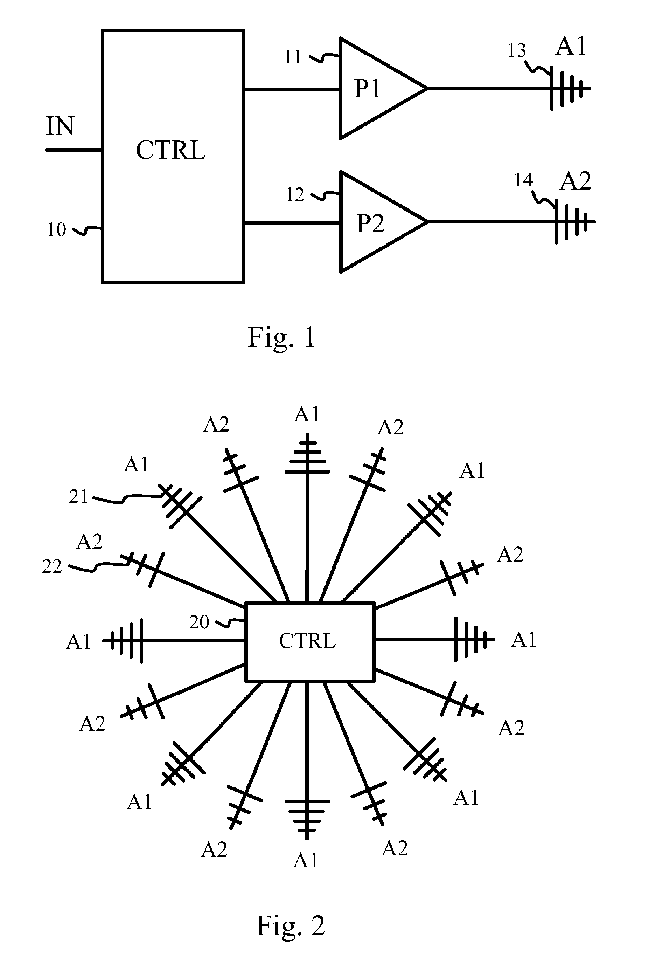

An illustration of the principle of the system according to the present invention is presented in Fig. 1 as one simple examplary implementation. The incoming radio-frequency signal (IN) that contains the sum of the desired transmission components on the desired radio channels is processed in the control unit 10 (CTRL) for example so that if the amplitude of the signal stays below a predetermined limit, only the amplifier unit 11 (P1) is kept operational, supplying the amplified signal to the first antenna or antenna element 13 (A1). If the amplitude exceeds the determined limit, part of the signal is conveyed to the second amplifier unit 12 (P2) and further to the antenna or antenna element 14 (A2). The control unit 10 ensures that the sum of the amplitudes of the signals conveyed to both amplifier units is equal to the incoming signal (IN). Finally, the amplitudes of the fields generated by the transmission antennas 13, 14 are summed in the far field where the signals are received and detected.

In one embodiment of the principle of the invention, the output signal of at least one signal branch differs from the amplitude-scaled input signal of the system. This means that if that transmission signal branch alone is operational, the desired signal is not detected correctly at the receiving end. However, the set of input signals of the signal branches is modified so that the set of a number of transmission components which is formed is summed at the receiving end, for example in the far field of the transmitters, resulting in the desired signal. On the other hand, the input signals are modified so that amplifiers are activated according to the desired output power, maximizing the efficiency. This means that the linear range of each individual amplifier is not exceeded and, on the other hand, unnecessary amplifiers are not kept operational. In other words, the number of the employed signal branches is minimized in one embodiment of the present invention, considering the required total output power.

In the following section, different examples of the practical implementation of the present invention are presented.

If the antennas of Fig. 1 are dipoles disposed at a suitable distance from each other, the summation in the far field takes place as desired where the remainder of the distances measured from the point of reception to the dipoles remains within certain limits. For example, if the dipoles are disposed one upon the other in a tower, the summation is effected correctly far from the tower. On the other hand, distances to the dipoles differ in length near the tower, and the signals will not be summed as desired. This can be observed as non-linearity in the reception. The internal signal-to-interference ratio of the desired frequency band becomes poorer and, in addition, undesired interference signals are created outside the desired band.

In practice, it is useful to dispose the antennas in one or more antenna groups after the output stages so that the elements of the antenna groups are suitably phased. In this manner, it is for example possible to set the phase difference between two different antenna groups to be as small as possible, whereupon the direction patterns of the groups become as uniform as possible.

One example of such implementation is presented in Figure 2. The figure includes two types of antenna elements. The antenna elements 21 indicated as A1 represent those passive or active antennas which belong to the first antenna group. The antenna elements 22 indicated as A2, in turn, represent those passive or active antennas which belong to the second antenna group. With the arrangement presented in the figure, it is possible to make the direction pattern of both the first and the second antenna group quite omnidirectional and cophasal. In this manner, the non-linearity caused by the phase difference between the first and the second group can be minimized.

In one embodiment of the present invention, the antennas of different antenna groups are disposed one upon the other and as close to each other as possible.

The signal directed to one of the antenna groups may also be predistorted so that the non-linearity stays within allowable limits in all radiating directions. In this case, the greatest linearity is achieved when there is a small delay difference between signals from the different groups.

The control unit 20 of Fig. 2 corresponds to the control unit 10 of the figure illustrating the inventive principle (Fig. 1).

The operation of the control unit (CTRL) 10, 20 may for example be based on adjusting the amplitude or the phase of the parallel signal branches. There are many different ways of controlling the level, i.e. the amplitude, of the signals which are conveyed to the antennas. If there are two linear amplifiers to be controlled, the employed control function may be for example:

If $I \leq A_{\max} / \sqrt{2}$ :

$$O_1 = I\sqrt{2}$$
$$O_2 = 0 \, , \hspace{6cm} (1)$$

if $I > A_{\max} / \sqrt{2}$ :

$$O_1 = A_{\max}$$
$$O_2 = \left(I - A_{\max}\right), \tag{2}$$

wherein $I$ is the amplitude of the incoming signal, $O_1$ is the amplitude of the signal outgoing to the first amplifier, $O_2$ is the amplitude of the signal outgoing to the second amplifier and $A_{\max}$ is the maximum amplitude that may be input to the amplifier. The term $\sqrt{2}$ is needed because with low signal levels only one antenna is employed, whereby the signal level detected in the far field is lower than by using both of the antennas.

If two linear amplifiers are used, the benefit provided by the invention remains practically quite small. The efficiency may be improved, for example in the case of two antennas or antenna groups, so that one of the amplifiers is set to operate only at the maximum amplitude, whereby the amplifier provides constant output power at the upper limit of its linear range. The efficiency of such amplifier is better than that of a linear amplifier wherein the input power may vary. In this case, the signals which are input to the amplifiers may be formed for example as follows:

If $I \leq A_{\max} \big/ \sqrt{2}$ :

$$O_{LIN} = I\sqrt{2}$$
$$O_{CW} = 0, \tag{3}$$

if $I > A_{\max} \big/ \sqrt{2}$ :

$$O_{LIN} = I - A_{\max}$$
$$O_{CW} = A_{\max}, \tag{4}$$

wherein $I$ is the amplitude of the incoming signal, $O_{LIN}$ is the amplitude of the signal outgoing to the linear amplifier (adjustable power), $O_{CW}$ is the amplitude of the signal outgoing to the amplifier which is able to provide only the maximum amplitude and $A_{\max}$ is the maximum amplitude that can be supplied to the amplifiers.

According to the examples referred to above, the signals which are input to the amplifiers may be formed to according to need. The benefit obtained from the configuration increases as the number of the antenna groups is raised. For example, a design of four antennas or antenna groups which transmit different signals may be implemented so that only one of the amplifiers is linear and the three others transmit only the maximum amplitude or nothing at all. The total efficiency may also be improved through optimization of the maximum levels of the amplifiers in different antenna groups so that the amplitude powers are raised in those antenna groups which are used rarely according to the amplitude distribution of the modulation. In this manner it is possible to increase the number of the employed antennas at the most general amplitude levels and to better utilize the amplification provided by the antennas. The downside in increasing the number of signal branches and antennas (antenna groups) is that the more there are antennas (antenna groups) that transmit different content, the higher is the risk of interference near the transmitter.

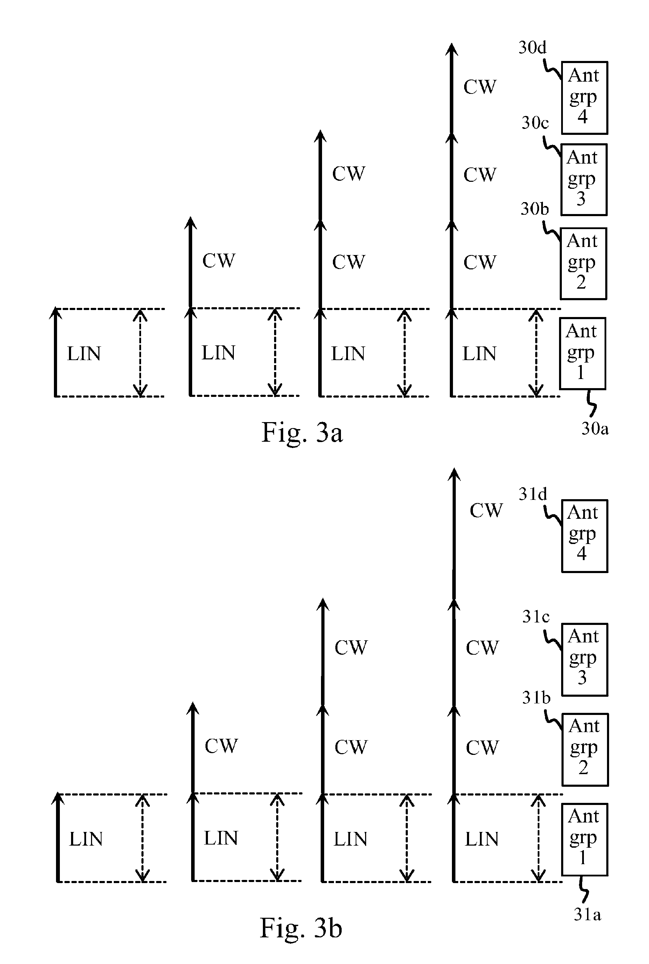

Figures 3a and 3b show examples of how the desired amplitude levels may be formed in the case of four antenna groups. In the case of Fig. 3a there are four different antenna groups 30a-30d and four parallel amplifiers, the outputs of which are directed to the antenna groups, respectively. One of the amplifiers LIN is a linearly adjustable amplifier wherein the output is continuously adjustable between 0 ... -Pmax,lin. This amplifier LIN is coupled to the first antenna group 30a. The other amplifiers CW output either their maximum power or are completely inactivated. These amplifiers CW are coupled to the antenna groups 30b-30d, respectively. In the example of Fig. 3a the maximum output amplitude of the adjustable amplifier LIN and the output amplitudes of the other amplifiers CW are equal to each other. As seen from the figure, the presented arrangement is able to provide any output amplitude (and thereby any output power) which is up to four times the output amplitude of one amplifier. On the other hand, in the case of low output amplitudes some of the amplifier branches are inactivated which is essential for maximizing the efficiency.

The example of Fig. 3b presents a similar arrangement to that of the example of Fig. 3a. The difference relative to the previous one is that the amplifiers which give fixed power may vary with regard to each other in their output power. As in the example of Fig. 3a, the adjustable amplifier LIN is coupled to the antenna group 31a and the fixed amplifiers CW, from the lowest-power to the highest-power, are coupled to the antenna groups 31b, 31c and 31d, respectively. With this configuration it is possible to transmit even higher output power where necessary.

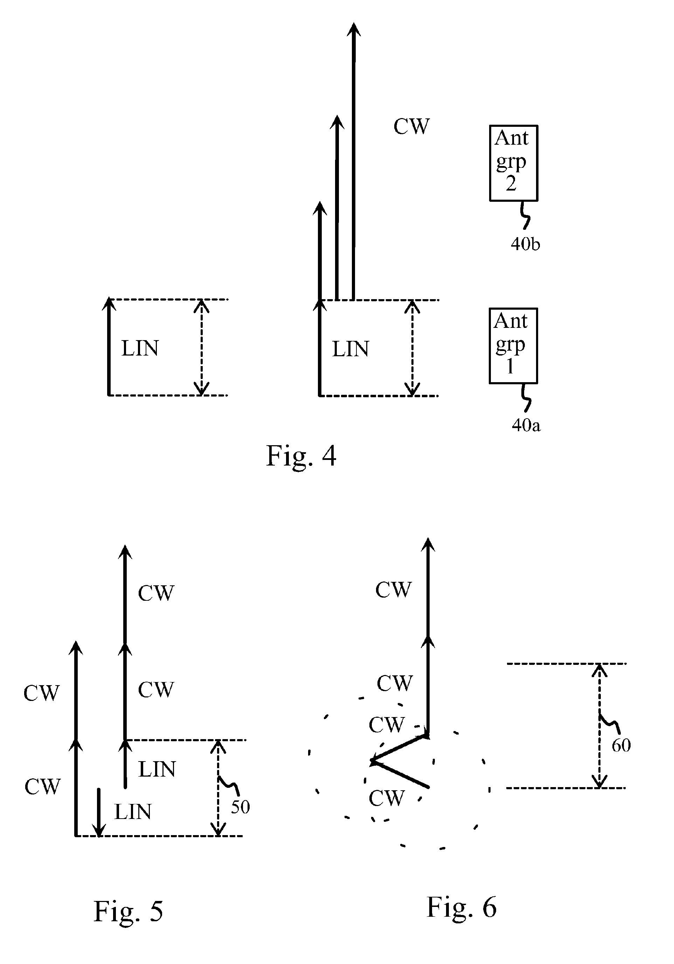

In the known technology, it is also possible to implement the output amplifier so as to maintain good efficiency, provided that the amplifier operates on a few determined power levels. Fig. 4 presents an example of one such configuration. The signal of the linear amplifier LIN is supplied to the first antenna group 40a and the signal of the amplifier CW which operates at specific determined power levels is supplied to the second antenna group 40b. This configuration provides the advantage that the linear amplifier may have a lower power level than when the other amplifier is able to transmit only one signal level.

In the present invention, the control unit may also adjust the phases of the signals. Fig. 5 presents an example of an implementation wherein an input signal having its phase rotated for 180 degrees compared to the phase of the other signal branches is supplied to the linear amplifier, where necessary. In this manner, the adjustment range 50 of the linear amplifier is doubled. At the same time, however, more power loss is created than in the normal case because the signals of opposite phases cancel each other in the far field.

Fig. 6 presents an example of an implementation where no linear amplifier is employed, but instead the desired variation in the amplitudes is effected only by adjusting the phases. If there are only two antenna groups, the phase of the signals directed to the amplifiers may be written out as follows:

$$\phi_{out}^{1} = \arccos(I / I_{\max})$$

$$\phi_{out}^{2} = -\phi_{out}^{1} \qquad\qquad (5)$$

wherein $\phi_{out}^{1}$ is the phase deviation of the signal supplied to the first amplifier compared with the original signal, $\phi_{out}^{2}$ is the phase deviation of the signal supplied to the second amplifier compared with the original signal, $I_{\max}$ is the maximum amplitude of the incoming signal and $I$ is the amplitude of the incoming signal. The amplifiers are continuously controlled at their maximum amplitude. With the adjustment principle according to Fig. 6 it is possible to use two amplifiers to generate one phase-adjustable amplifier with double amplitude 60, at the maximum. By the effect of the phase adjustment, these two amplifiers of the fixed amplitude behave as one linearly adjustable amplifier. In the example of Fig. 6, the maximum input amplitudes of the two other amplifiers are higher than the maximum input amplitudes of the phase-controlled amplifiers. The amplifiers may also have common maximum output power, or the output powers of the amplifiers may vary independently of each other. In the same way, the features presented in connection with the examples of Fig. 3a-6 are not limited merely to the amplitude proportions presented in the figures, but instead said different features and different amplitude proportions are applicable in examples based on the amplitude adjustment as well as phase adjustment.

Generally, the computing operations performed by the control unit employed in the invention may be executed by a microprocessor and a computer program installed on it. With the software it is thus possible to control the input signal of each output amplifier, and thereby to control the output signals of each signal branch as desired and as a function of time.

The present invention is broadly applicable in all technologies and applications where signal transmission branches may be controlled in the above described manner. The present invention is applicable for example in the broadcast-type signal transmission systems. On the other hand, the invention is also applicable in satellite transmission systems where power consumption is an essential parameter in terms of system design. One application possibility includes devices which utilize ultra-wideband technology (UWB) where minimizing the power consumption is also essentially important.

The invention is not limited merely to the exemplifying embodiments referred to above; instead, many variations are possible within the scope of the inventive idea defined by the claims.

**Claims**

1. A method for improving efficiency in a radio transmission system, wherein an input signal (IN) of the system is divided into at least two parallel signal branches comprising an output amplifier (11, 12) and a transmission antenna (13, 14, 21, 22),
   **characterized in that** the method comprises the step of:

   adjusting (10, 20) the input signals of the signal branches so that an output signal of at least one signal branch is not the input signal (IN) of the system multiplied by any constant, and that a received signal which is summed in a far field of the transmission antennas (13, 14, 21, 22, 30a-d, 31a-d, 40a-b) is the input signal (IN) of the system multiplied by a constant.

2. The method according to claim 1, **characterized in that** the method further comprises the step of:

   adjusting (10, 20) the input signal of at least one output amplifier (11, 12) within the linear operating range (LIN) of that output amplifier.

3. The method according to claim 1 or 2, **characterized in that** the method further comprises the step of:

   controlling (10, 20) at least one output amplifier (11, 12) so that the output power of the output amplifier is zero or equal to at least one constant value (CW).

4. The method according to any one of the preceding claims 1 to 3, **characterized in that** the method further comprises the step of:

   adjusting (10, 20) the maximum amplitude or phase or both of the output signal of at least one output amplifier (11, 12).

5. The method according to any one of the preceding claims 1 to 4, **characterized in that** the method further comprises the steps of:

   controlling (10, 20) one linearly adjustable output amplifier (LIN); and
   controlling (10, 20) a desired number of output amplifiers of constant power (CW), depending on the required output power.

6. The method according to any one of the preceding claims 1 to 5, **characterized in that** the method further comprises the step of:

   defining an antenna group (30a-d, 31a-d, 40a-b) as a set of antennas which are coupled to similar types of output amplifiers.

7. The method according to claim 6, **characterized in that** the method further comprises the step of:

   disposing the antennas of each antenna group (30a-d, 31a-d, 40a-b) on the same plane so that direction patterns of the antenna groups are substantially uniform.

8. A system for improving efficiency in a radio transmission system, the system comprising:

   at least two parallel signal branches divided from an input signal (IN) of the system and comprising an output amplifier (11, 12) and a transmission antenna (13, 14, 21, 22);

   **characterized in that** the system further comprises:

   a control unit (10, 20) for adjusting the input signals of the signal branches so that an output signal of at least one signal branch is not the input signal (IN) of the system multiplied by any constant, and that a received signal which is summed in a far field of the transmission antennas (13, 14, 21, 22, 30a-d, 31-d, 40a-b) is the input signal (IN) of the system multiplied by a constant.

9. The system according to claim 8, **characterized in that** the system further comprises:

said control unit (10, 20) for adjusting the input signal of at least one output amplifier (11, 12) within the linear operating range (LIN) of that output amplifier.

10. The system according to claim 8 or 9, **characterized in that** the system further comprises:

said control unit (10, 20) for controlling at least one output amplifier (11, 12) so that the output power of the output amplifier is zero or equal to at least one constant value (CW).

11. The system according to any one of the preceding claims 8 to 10, **characterized in that** the system further comprises:

said control unit (10, 20) for adjusting the maximum amplitude or phase or both of the output signal of at least one output amplifier (11, 12).

12. The system according to any one of the preceding claims 8 to 11, **characterized in that** the system further comprises:

said control unit (10, 20) for controlling one linearly adjustable output amplifier (LIN); and
said control unit (10, 20) for controlling at least one output amplifier of constant power (CW), depending on the required output power.

13. The system according to any one of the preceding claims 8 to 12, **characterized in that** the system further comprises:

a set of antennas defined as an antenna group (30a-d, 31a-d, 40a-b), wherein the antennas are coupled to similar types of output amplifiers.

14. The system according to claim 13, **characterized in that** the system further comprises:

the antennas of each antenna group (30a-d, 31a-d, 40a-b) disposed on the same plane so that direction patterns of the antenna groups are substantially uniform.

15. A computer program for improving efficiency in a radio transmission system, wherein an input signal (IN) of the system is divided into at least two parallel signal branches comprising an output amplifier (11, 12) and a transmission antenna (13, 14, 21, 22), and wherein the computer program comprises program code, **characterized in that** when executed on a data processing device, the computer program is arranged to execute the step of:

adjusting (10, 20) the input signals of the signal branches so that an output signal of at least one signal branch is not the input signal (IN) of the system multiplied by any constant, and that a received signal which is summed in a far field of the transmission antennas (13, 14, 21, 22, 30a-d, 31a-d, 40a-b) is the input signal (IN) of the system multiplied by a constant.

Fig. 1

Fig. 2

Fig. 3a

Fig. 3b

CW

Ant
grp
2

40b

LIN

LIN

Ant
grp
1

40a

Fig. 4

CW

CW

CW

CW

LIN

LIN

50

CW

CW

CW

CW

60

Fig. 5

Fig. 6

Europäisches
Patentamt

European
Patent Office

Office européen
des brevets

**EUROPEAN SEARCH REPORT**

Application Number

EP 09 15 5736

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2006/135079 A1 (BARNETT KENNETH C [US] ET AL) 22 June 2006 (2006-06-22) * paragraphs [0007], [0008], [0022], [0033] - [0043]; figures 3,4 * ----- | 1-15 | INV. H03F1/02 H03F3/24 H03F3/72 H03F3/68 |
| X | US 6 473 600 B1 (DVORKIN VLADIMIR A [US]) 29 October 2002 (2002-10-29) * column 1, lines 8-10 * * column 1, line 62 - column 2, line 52 * * column 3, line 16 - column 5, line 57; figures 3-5 * ----- | 1-15 | |
| X | US 2005/143024 A1 (SUNG JIN B [KR] ET AL SUNG JIN BONG [KR] ET AL) 30 June 2005 (2005-06-30) * paragraphs [0002], [0018] - [0021], [0034] - [0038]; figure 6 * ----- | 1-15 | |
| X | US 2007/129024 A1 (KIKUMA TOMOHIRO [JP]) 7 June 2007 (2007-06-07) * paragraphs [0001], [0021] - [0029], [0036] - [0063]; figure 1 * ----- | 1-15 | |

TECHNICAL FIELDS
SEARCHED      (IPC)

H03F

The present search report has been drawn up for all claims

| Place of search | Date of completion of the search | Examiner |
|---|---|---|
| The Hague | 24 June 2009 | Goethals, Filip |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 09 15 5736

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2009

| Patent document cited in search report | | Publication date | Patent family member(s) | | Publication date |
|---|---|---|---|---|---|
| US 2006135079 | A1 | 22-06-2006 | CA | 2590659 A1 | 29-06-2006 |
| | | | CN | 101124747 A | 13-02-2008 |
| | | | EP | 1829246 A2 | 05-09-2007 |
| | | | JP | 2008524971 T | 10-07-2008 |
| | | | KR | 20070094000 A | 19-09-2007 |
| | | | WO | 2006069321 A2 | 29-06-2006 |
| US 6473600 | B1 | 29-10-2002 | CN | 1364351 A | 14-08-2002 |
| | | | DE | 60007110 D1 | 22-01-2004 |
| | | | DE | 60007110 T2 | 09-09-2004 |
| | | | WO | 0145301 A1 | 21-06-2001 |
| | | | EP | 1171965 A1 | 16-01-2002 |
| | | | JP | 2003517251 T | 20-05-2003 |
| US 2005143024 | A1 | 30-06-2005 | KR | 20050065887 A | 30-06-2005 |
| US 2007129024 | A1 | 07-06-2007 | CN | 1980085 A | 13-06-2007 |
| | | | JP | 2007158913 A | 21-06-2007 |

EPO FORM P0459

For more details about this annex : see Official Journal of the European Patent Office, No. 12/82